# EUROPÄISCHE PATENTANMELDUNG

(11) **EP 2 375 258 A1**
(43) Veröffentlichungstag der Anmeldung: **12.10.2011**
(21) Anmeldenummer: 11002779.4
(22) Anmeldetag: 02.04.2011
(51) Int. Cl.: G01R 11/24, F16B 41/00, H02B 1/06

(54) **Elektronischer Haushaltszähler mit Plombierschraube**

(30) Priorität: 08.04.2010 DE 202010004692 U
(71) Anmelder: ABN Braun AG, 74196 Neuenstadt (DE)
(72) Erfinder: Braun, Werner, 74906 Bad Rappenau (DE); Schmiederer, Roland, 77876 Kappelrodeck (DE)
(74) Vertreter: Schmid, Barbara

(57) **Zusammenfassung**

Ein elektronischer Haushaltszähler (10) besitzt ein Gehäuse (12), in dessen Frontbereich eine durch eine Plombe (26) zu schützende Plombierschraube endet, wobei die Plombierschraube (20) von einer Abdeckung (16) abgedeckt werden kann.

Diese Abdeckung (16) ist am Gehäuse (12) klappbar, steckbar oder verschiebbar so angebracht, dass die Plombierschraube im geschlossenen Zustand der Abdeckung (16) von außen abgedeckt ist, während die die Plombierschraube sichernde Plombe (26) von außen frei zugänglich ist.

## Beschreibung

### TECHNISCHES GEBIET

Die Erfindung betrifft einen elektronischen Haushaltszähler (eHZ), der im Zuge des Wandels im Energiemarkt den bisherigen mechanischen Ferraris-Zähler ablöst. Der elektronische Haushaltszähler soll den Privat- und Gewerbekunden durch zeitnahe Verbrauchsinformationen und variable Tarife für den bewussten Umgang mit Energie sensibilisieren.

Bei Neuanlagen kann ein elektronischer Haushaltszähler direkt auf den neuen Zählerplatz gesteckt werden. Bei der Umrüstung bestehender Anlagen mit einem für einen Ferraris-Zähler normierten Zählerkreuz wird zuerst ein neu entwickelter eHZ-Adapter auf dem Zählerkreuz montiert und dann der elektronische Haushaltszähler auf den eHZ-Adapter aufgesteckt.

### STAND DER TECHNIK

Bei elektronischen Haushaltszählern ist es bekannt, mittels einer Plombierschraube die Lage des elektronischen Haushaltszählers an seinem Bestimmungsort zu sichern. Damit soll verhindert werden, dass der Zähler beispielsweise zu Manipulationszwecken von seinem Zählerplatz unbefugtermaßen entnommen wird. Eine solche Plombierschraube greift von der Frontseite des elektronischen Zählers aus quer durch sein Gehäuse hindurch und verankert sich beispielsweise in einem Adapter, an den der Zähler elektrisch angedockt worden ist. Das obere Ende der Plombierschraube, das aus der Frontseite des elektronischen Haushaltszählers nach vorne herausragt, wird von einer wannen- oder haubenartigen Abdeckung abgedeckt.

Zum Entfernen des elektronischen Haushaltszählers wird die Abdeckung weggenommen und die dann frei liegende Plombe von der Plombierschraube entfernt. Anschließend kann dann die Plombierschraube entsprechend verdreht und dadurch der Halt des elektronischen Haushaltszählers an dem beispielsweise Adapter, an dem der Zähler angedockt ist, gelöst werden. Die Abdeckung selber kann von jedermann von der Frontseite des elektronischen Haushaltszählers weggenommen und die Plombierschraube dadurch mit ihrer Plombe freigelegt werden.

### DARSTELLUNG DER ERFINDUNG

Ausgehend von diesem Stand der Technik liegt der Erfindung die Aufgabe zugrunde, die Verplombung einer einen elektronischen Haushaltszähler in seiner Lage fixierenden Plombierschraube möglichst sicher zu gestalten.

Diese Erfindung wird durch die Merkmale des Hauptanspruches gelöst. Sinnvolle Weiterbildungen der Erfindung sind Gegenstand von sich daran anschließenden weiteren Ansprüchen.

Die Erfindung beinhaltet, dass die bei der Verplombung vorgesehene Plombe nicht nur die Plombierschraube selber an ihrer Verdrehung sichert, sondern dass die Plombe gleichzeitig auch verhindert, dass die Abdeckung von dem oberen Ende der Plombierschraube abgenommen werden kann. Mit einer derartigen Verplombung ist also das unbefugte Wegnehmen der Abdeckung von der Plombierschraube und damit auch von der die Plombierschraube sichernden Plombe nicht möglich. Dadurch, dass bei dieser Plombiertechnik die Plombe von außen frei zugänglich ist, können Manipulationen an der Plombe unmittelbar und besser erkannt werden, als es durch die bekanntermaßen die Plombe abdeckende transparente Abdeckung der Fall ist. Aufgrund von Reflex-und Spiegeleffekten muss nämlich die vorbekannte Plombe durch die Abdeckung hindurch schon sehr genau und von nahem betrachtet werden, um Manipulationen an derselben erkennen zu können.

Nach einem in der Zeichnung dargestellten Ausführungsbeispiel hat es sich als günstig herausgestellt, die Abdeckung als einen am Gehäuse des elektronischen Haushaltszählers angelenkten haubenartigen Deckel auszubilden. In seinem an der Frontseite des elektronischen Haushaltszählers anliegenden Zustand stülpt sich dann ein Bereich der Deckelplatte dieses Deckels von oben beziehungsweise von außen auf das obere Ende der Plombierschraube und deckt dieselbe dadurch ab. Ferner besitzt die Deckelplatte eine ringförmige Vertiefung, in der die die Plombierschraube sichernde Plombe Platz findet. Die Vertiefung ist so groß, dass die Plombe nicht aus der äußeren Ebene der Deckelplatte des Deckels herausragen kann. Die das obere Ende der Plombierschraube haubenartig abdeckende Auswölbung in der Deckelplatte des Deckels besitzt zwei Öffnungen in ihrer Wandung, so dass ein durch die Plombierschraube hindurchgezogener Plombierdraht auch durch diese haubenartige Auswölbung des Deckels mit hindurchgefädelt werden kann und dass damit die Plombe von außen auf dem Deckel Platz finden kann. Die Plombe ist dadurch unmittelbar und direkt sichtbar auf der Außenseite des Deckels vorhanden. Gleichzeitig wird der Deckel in seiner auf der Frontseite dicht anliegenden, das obere Ende der Plombierschraube abdeckenden Lage gehalten. Der Deckel kann erst nach Lösen der Plombe von der Frontseite des elektronischen Haushaltszählers aufgeklappt oder in sonstiger Weise von der Plombierschraube entfernt werden.

Nach dem in der Zeichnung dargestellten Ausführungsbeispiel hält sich der Deckel in seinem an der Frontseite des elektronischen Haushaltszählers anliegenden Zustand reibschlüssig oder insbesondere rastbar am Gehäuse des Zählers.

Nähere Einzelheiten zu der Ausbildung eines solchen durch eine Verplombung geschützten elektronischen Haushaltszählers und weitere Vorteile und Merkmale der Erfindung sind den in den Ansprüchen ferner angegebenen Merkmalen sowie dem nachstehenden Ausführungsbeispiel zu entnehmen.

### KURZE BESCHREIBUNG DER ZEICHNUNG

Die Erfindung wird im Folgenden anhand der in der Zeichnung dargestellten Ausführungsbeispiele näher beschrieben und erläutert. Es zeigen:
- Fig. 1: eine perspektivische Draufsicht auf einen elektronischen Haushaltszähler nach der Erfindung, in seinem verplombten Zustand,
- Fig. 2: eine Darstellung, ähnlich der von Fig. 1, in seinem noch nicht plombierten Zustand,
- Fig. 3: eine Teil-Draufsicht auf die Frontseite des elektronischen Haushaltszählers aus Richtung des Pfeils III in Fig. 1,
- Fig. 4: einen Schnitt längs der Linie IV-IV in Fig. 3.

### WEGE ZUM AUSFÜHREN DER ERFINDUNG

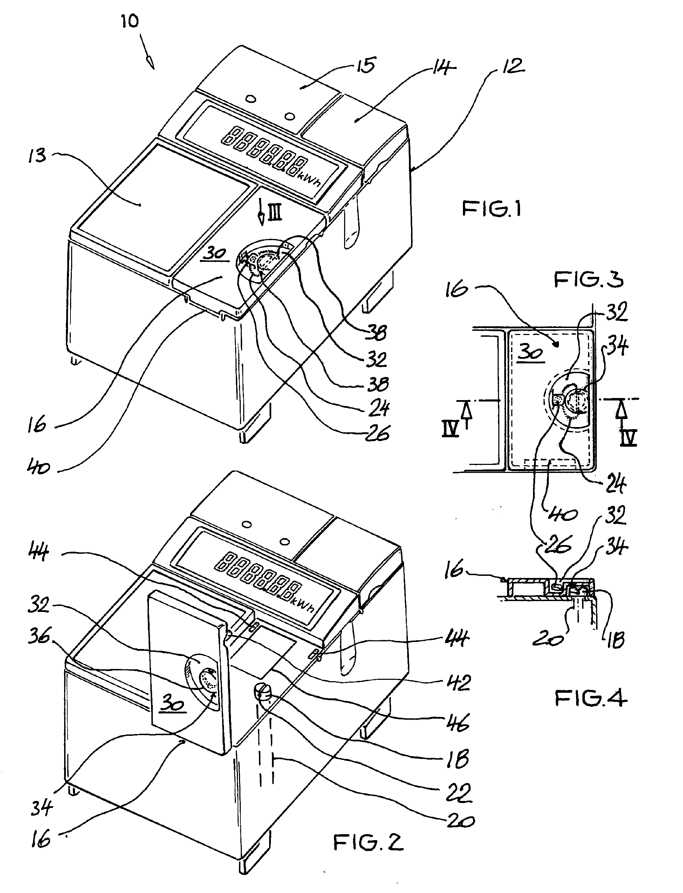

Ein elektronischer Haushaltszähler 10 besitzt ein quaderförmiges Gehäuse 12 mit einer zur Zeichenebene parallelen Frontseite, auf der insbesondere auch unter einer im unteren linken Eckbereich vorhandenen optisch durchsichtigen Abdeckung 13 Angaben zum Hersteller des Zählers, zur Art desselben und darüber hinaus verbrauchstechnische Angaben abgelesen werden können. Unter der oberen rechten Abdeckung 14 ist eine dem jeweiligen Kunden des Zählers zugängliche optische Schnittstelle vorhanden. In der oberen linken Ecke 15 ist ein Informationsfeld für den Hersteller des Zählers betreffende Angaben vorhanden. Außerdem befindet sich auf der Frontseite ein in Fig. 1 geschlossener Deckel 16, der das obere Ende 18 einer Plombierschraube 20 abdeckt (Fig. 1) beziehungsweise nicht abdeckt (Fig. 2). Die Plombierschraube 20 besitzt eine Durchbohrung 22 im Bereich ihres oberen Endes 18, durch die in bekannter Weise ein Plombierdraht 24 hindurchgefädelt und durch eine Plombe 26 gesichert werden kann, so wie dies an sich in der Plombierungstechnik bekannt ist.

Der Deckel 16 besitzt in seiner Deckelplatte 30 eine ringförmige Vertiefung 32. Diese ringförmige Vertiefung besitzt wiederum eine haubenartige, im Querschnitt kreisförmige Auswölbung 34. Mit dieser Auswölbung 34 deckt der Deckel 16 das obere Ende 18 der Plombierschraube 20 von oben, das heißt von der Frontseite aus, ab, so wie dies in Fig. 1, 3 und 4 dargestellt ist. In dem Mantel 36 dieser haubenartigen Auswölbung 34 sind zwei einander gegenüber liegende Öffnungen 38 (Fig. 1), die mit der Durchbohrung 22 der Plombierschraube 20 fluchten. Dadurch lässt sich der Plombierdraht 24 durch die Durchbohrung 22 der Plombierschraube 20 hindurchfädeln und dabei gleichzeitig auch durch den Mantel 36 der haubenartigen Auswölbung 34 hindurchfädeln. Die beiden Enden des Plombierdrahtes 24 können dann durch eine Plombe 26 aneinander fixiert werden. Die Plombe 26 selber findet dann in der ringförmigen Vertiefung 32 Platz. Die Vertiefung 32 ist so groß, dass einerseits die Plombe 26 in sie vollständig hineingelegt werden kann und andererseits die Plombe 26 nicht nach außen aus der Deckelplatte 32 herausragt.

Die Plombe 26 wird angebracht, wenn der Deckel vollständig an dem oberen Ende 18 der Plombierschraube anliegt, sich also in seiner in Fig. 1 verschlossenen Stellung befindet. Der Deckel 16 kann dann ohne Zerstören des Plombierdrahtes 24 nicht in seine in Fig. 2 aufgeklappte Stellung verschwenkt werden.

Der in seiner in Fig. 1 verschlossenen Stellung dargestellte, mittels eines Scharniers 40 am Gehäuse 12 angelenkte Deckel (16) greift mit an seiner rechten und linken Seite auskragenden Rastzapfen 42 in entsprechend ausgebildete Rastvertiefungen 44, die in dem Gehäuse 12 ausgebildet sind.

Durch den Deckel 16 kann nicht nur das obere Ende 18 der Plombierschraube 20 sondern auch ein Feld 46 abgedeckt werden. Dieses Feld 46 ist zum Anbringen (Aufkleben) einer Eichmarke bestimmt. Der durch die Verplombung gesicherte Deckel 16 verhindert also auch ein unbefugtes Hantieren an der Eichmarke.

## Patentansprüche

1. Elektronischer Haushaltszähler (10)
- mit einem Gehäuse (12), in dessen Frontbereich eine durch eine Plombe (26) zu schützende Plombierschraube (20) endet,
- mit einer Abdeckung (16) für die Plombierschraube (20),
- **dadurch gekennzeichnet, dass**
- die Abdeckung (16) am Gehäuse (12) klappbar, steckbar oder verschiebbar so angebracht ist, dass in ihrem geschlossenen Zustand
- - die Plombierschraube (20) von außen abgedeckt ist und
- - die die Plombierschraube (20) sichernde Plombe (26) von außen frei zugänglich ist.

2. Zähler nach Anspruch 1,
- **dadurch gekennzeichnet, dass**
- die Abdeckung ein am Gehäuse (12) angelenkter haubenartiger Deckel (16) ist,
- die Deckelplatte (30) des Deckels (16) eine ringförmige Vertiefung (32) zur Aufnahme der Plombe (26) besitzt,
- der Boden der Vertiefung (32) eine haubenartige Auswölbung (34) besitzt, die im geschlossenen Zustand des Deckels (16) den oberen Endbereich (18) der Plombierschraube (20) abdeckt,
- in den Mantel (36) der haubenartigen Auswölbung (34) zwei Öffnungen (38) zum Hindurchführen eines durch die Plombierschraube (20) hindurchgefädelten Plombierdrahtes (24) vorhanden sind.

3. Zähler nach Anspruch 1,
- **dadurch gekennzeichnet, dass**
- der Deckel (16) in seinem geschlossenen Zustand reibschlüssig oder rastbar (42, 44) am Gehäuse (12) haltbar ist.
